# EUROPÄISCHE PATENTSCHRIFT

(11) **EP 3 270 369 B1**
(45) Veröffentlichungstag und Bekanntmachung des Hinweises auf die Patenterteilung: **27.05.2020**
(21) Anmeldenummer: 16178827.8
(22) Anmeldetag: 11.07.2016
(51) Int. Cl.: G09F 9/33

(54) **BAUGRUPPE MIT EINER MEHRZAHL VON LEDS UND VIDEOBOARD**
ASSEMBLY WITH A PLURALITY OF LEDS AND VIDEO BOARD
COMPOSANT COMPRENANT UNE PLURALITE DE DEL ET CARTE VIDEO

(43) Veröffentlichungstag der Anmeldung: 17.01.2018
(73) Patentinhaber: B1 LED Videoboard UG, 48151 Münster (DE)
(72) Erfinder: DÖKER, Werner, 48151 Münster (DE)
(74) Vertreter: Schiffer, Axel Martin

(56) Entgegenhaltungen:
- EP-A2- 0 182 254
- WO-A1-80/01860
- CN-U- 201 561 403
- CN-Y- 2 225 081
- KR-A- 20080 072 154

## Beschreibung

Die vorliegende Erfindung bezieht sich in einem ersten Aspekt auf eine Baugruppe mit den Merkmalen des Obergriffs des Anspruchs 1. Derartige Baugruppen weisen eine Mehrzahl von Leuchtdioden auf, die auf der Baugruppe durch Zwischenräume beabstandet angeordnet sind. Sie werden insbesondere als sogenannte LED-Leuchtmittel sehr vielseitig eingesetzt und gehören zu den energiesparenden Leuchtmitteln. Außerdem betrifft die Erfindung ein Videoboard mit mindestens einer erfindungsgemäßen Baugruppe.

In CN201561403U ist eine gattungsgemäße Anordnung mit einer Mehrzahl von Leuchtdioden beschrieben, wobei die Räume zwischen den Leuchtdioden jeweils mit einem hitzebeständigen Material verfüllt sind.

CN 2225081Y offenbart eine Anordnung mit einer feuerfesten und optisch transparenten Frontplatte.

Eine Aufgabe der Erfindung ist es, Erzeugnisse der genannten Art zu verbessern.

Diese Aufgabe wird nach einem ersten Aspekt der Erfindung durch ein Erzeugnis, nämlich durch eine Baugruppe mit den Merkmalen des Anspruchs 1 gelöst.

Erfindungsgemäß ist die Baugruppe der oben genannten Art dadurch weitergebildet, dass die Zwischenräume zwischen den Leuchtdioden ein hitzebeständiges oder feuerfestes oder nicht brennbares Material aufweisen und/oder dass eine Frontplatte vorhanden ist, die ein hitzebeständiges oder feuerfestes oder nicht brennbares Material aufweist.

Durch die Erfindung wird ein brandspezifisch und sicherheitstechnisch optimiertes Videoboard bereitgestellt.

Besonders gute Eigenschaften im Hinblick auf die Hitze- und Brandbeständigkeit werden erzielt, wann die Zwischenräume zwischen den Leuchtdioden vollständig mit dem hitzebeständigen, feuerfesten oder nicht brennbaren Material gefüllt sind und/oder wenn eine Frontplatte vorhanden ist, die aus dem hitzebeständigen, feuerfesten oder nicht brennbaren Material besteht.

Vorzugsweise weisen die Zwischenräume zwischen den Leuchtdioden der Baugruppe ein anorganisches, keramisches oder metallisches Material, besonders vorzugsweise Glas, Glasfaser oder Aluminium oder ein anderes Material der Brandschutzklasse A1 auf.

Das erfindungsgemäße Videoboard kann bevorzugt ein Gehäuse, Energieversorgungsmittel und Ansteuereinrichtungen für die mindestens eine Baugruppe aufweisen. Vorteilhaft kann auch sein, eine Mehrzahl von erfindungsgemäßen Videoboards nebeneinander, insbesondere matrixartig, anzuordnen. Besonders bevorzugt ist dabei eine kachelartige Anordnung dergestalt, dass eine geschlossene Fläche durch die Baugruppen der einzelnen Videoboards gebildet wird. Beispielsweise kann solch eine Anordnung an einer Gehäusewand angeordnet sein und zu Wiedergabe von Information, beispielsweise Werbung, dienen. Hierzu kann eine Ansteueranrichtung zum Ansteuern der Vielzahl von Videoboards vorhanden sein.

Im Zusammenhang mit der Beschreibung der vorliegenden Erfindung und mit der Definition des Gegenstandes der Patentansprüche soll unter einem anorganischen Material ein Material verstanden werden, das keinen Kohlenstoff, zumindest nicht in einer stöchiometrischen Konzentration, enthält. Zu den anorganischen Materialien in diesem Sinn gehören insbesondere die Metalle und deren Legierungen und deren nicht kohlenstoffhaltige Verbindungen, insbesondere die Metalloxide und Metallhalogenide aber auch Verbindungen und Gemische die Silizium enthalten, wie beispielsweise Gläser oder andere erstarrte anorganische Schmelzen, insbesondere die Silikatgläser. Aber auch mit Kohlenstoff (nicht in einer stöchiometrischen Konzentration) dotierte Metalle oder Metalllegierungen wie Stahl gehören zu den anorganischen Materialien in diesem Sinn.

Erfindungsgemäß sind die Leuchtdioden auf einer ersten Fläche angeordnet. Besonders vorzugsweise sind die Leuchtdioden auf dieser ersten Fläche matrixförmig angeordnet.

Die Einteilung von Materialien, insbesondere von Baustoffen, nach ihrer Brennbarkeit bzw. dem Brandverhalten erfolgte in Deutschland bislang gemäß DIN 4102 Teil 1 in zwei Baustoffklassen (zum Teil auch als Brennbarkeitsklassen oder - fachsprachlich nicht ganz korrekt - als Brandklassen bezeichnet) (siehe auch https://de.wikipedia.org/wiki/Brandverhalten#Brandverhalten_von_Baustoffen).

### Klasse A - nicht brennbare Baustoffe

Klasse A1 - ohne brennbare Bestandteile, Nachweis nach DIN 4102-1 erforderlich, sofern nicht in DIN 4102-4 benannt (z. B. Sand, Kies, Naturbims, Zement, Kalk, Schaumglas, Mörtel, (Stahl-)Beton, Steine, Bauplatten aus mineralischen Bestandteilen, reine Mineralfasern, Ziegel, Glas, Eisen und Stahl, aber kein Metallstaub)
Klasse A2 - in geringem Umfang mit brennbaren Bestandteilen, Nachweis nach DIN 4102-1 erforderlich, sofern nicht in DIN 4102-4 benannt (z. B. Gipskartonplatten nach DIN 18180 und geschlossener Oberfläche).

### Klasse B - brennbare Baustoffe

Klasse B1 - schwerentflammbar (z. B. Holzwolle-Leichtbauplatten nach DIN, Gipskartonplatten nach DIN 18180 und gelochter Oberfläche, Hartschaum-Wärmedämmplatten mit Flammschutzzusatz, Kunstharzputz, wenn er aus mineralischen Zuschlägen hergestellt wird und auf massivem und mineralischen Untergrund aufgebracht wird, verschiedene Bodenbeläge wie Eichenparkett, Guss- oder Walzasphalt-Estrich)
Klasse B2 - normalentflammbar (z. B. Holz ab bestimmten Abmessungen, Gipskarton-Verbundplatten, Hartschaum-Wärmedämmplatten ohne Flammschutzzusatz, verschiedene Kunststoffe und daraus hergestellte Tafeln oder Formstücke, elektrische Leitungen und verschiedene Bitumenbahnen sowie Dach- und Dichtungsbahnen. Bei den letzten drei ist ggf. durch Versuche nachzuweisen, dass sie nicht brennend abfallen.)
Klasse B3 - leichtentflammbar (alles, was nicht in B1 oder B2 eingruppiert werden kann)

Bis hin zur Baustoffklasse B1 gelten Baustoffe als selbstverlöschend. Ab Baustoffklasse B2 unterhält der Brand sich selbst, auch wenn die Brandursache entfällt.

Von Bedeutung ist außerdem die Europäische Norm EN 13501-1. Eine Vergleichstabelle, in der Klassifizierungen der Deutschen Norm DIN 4102 Teil 1 und der Europäische Norm EN 13501-1 gegenübergestellt sind, findet sich unter: https://de.wikipedia.org/wiki/Brandverhalten.

Erfindungsgemäß ist das hitzebeständige oder feuerfeste oder nicht brennbare Material in Form einer zweiten Fläche auf der ersten Fläche angebracht. Die zweite Fläche weist, sofern sie für das von den Leuchtdioden emittierte Licht nicht oder nicht in ausreichender Weise durchlässig ist, eine Mehrzahl von Ausnehmungen auf, die in der zweiten Fläche derart angeordnet sind, dass das von den Leuchtdioden emittierte Licht zumindest in flächennormaler Richtung nicht von der zweiten Fläche an der Abstrahlung gehindert wird.

Unter einem Material, das für das von den Leuchtdioden (LEDs) emittierte Licht nicht oder nicht in ausreichender Weise durchlässig ist, soll in diesem Zusammenhang jedes Material verstanden werden, dessen Absorptionscharakteristik, z.B. beschrieben durch den (optischen) Extinktionskoeffizienten, in dem relevanten optischen Spektralbereich eine durch die jeweilige Anwendung definierte bestimmungsgemäße Nutzung des von den Leuchtdioden (LEDs) emittierten Lichtes stören oder ausschließen würde.

Dieser Definition entsprechend soll unter einem Material, das für das von den Leuchtdioden emittierte Licht durchlässig oder zumindest in ausreichender Weise durchlässig ist, ein Material verstanden werden, dessen Absorptionscharakteristik, z.B. beschrieben durch den (optischen) Extinktionskoeffizienten, in dem relevanten optischen Spektralbereich eine durch die jeweilige Anwendung definierte bestimmungsgemäße Nutzung des von den Leuchtdioden (LEDs) emittierten Lichtes nicht stören oder jedenfalls nicht ausschließen würde.

Gemäß weiterer bevorzugter Ausführungsformen der Erfindung sind die Ausnehmungen mit einem hitzebeständigen oder feuerfesten oder nicht brennbaren Material verfüllt, das für das von den Leuchtdioden emittierte Licht durchlässig oder zumindest in ausreichender Weise durchlässig ist.

Gemäß weiterer bevorzugter Ausführungsformen der Erfindung sind auf den Leuchtdioden, insbesondere auf deren von der ersten Fläche abgewandten Seiten, jeweils für das Licht der Leuchtdioden zumindest ausreichend durchlässige Objekte aus einem hitzebeständigen oder feuerfesten oder nicht brennbaren Material befestigt, vorzugsweise mit diesen verklebt, das vorzugsweise Glasscheibchen aufweist.

Gemäß weiterer bevorzugter Ausführungsformen der Erfindung ist das hitzebeständige oder feuerfeste oder nicht brennbare Material in Form einer zweiten Fläche auf der ersten Fläche angebracht. Die zweite Fläche weist eine erste und eine zweite Teilfläche auf. Beide Teilflächen weisen eine Mehrzahl von Ausnehmungen auf, die in den beiden Teilflächen der zweiten Fläche derart angeordnet sind, dass das von den Leuchtdioden emittierte Licht zumindest in flächennormaler Richtung nicht von der zweiten Fläche an der Abstrahlung gehindert wird. An den Ausnehmungen in der von der ersten Fläche abgewandten Teilfläche sind jeweils für das Licht der Leuchtdioden zumindest ausreichend durchlässige Objekte aus einem hitzebeständigen oder feuerfesten oder nicht brennbaren Material, das vorzugsweise Glasscheibchen aufweist, auf der der ersten Fläche zugewandten Seite der von der ersten Fläche abgewandten Teilfläche befestigt, vorzugsweise mit dieser Teilfläche verklebt.

Unter dem Begriff Kleben soll in diesem Zusammenhang ein Fertigungsverfahren verstanden werden, das der Hauptgruppe der Fügeverfahren angehört. Wie das Schweißen und das Löten gehört auch das Kleben zu den fachsprachlich so genannten stoffschlüssigen Fügeverfahren der Fertigungstechnik. Durch Kleben werden Fügeteile mittels Klebstoff stoffschlüssig verbunden.

Der Klebstoff haftet an der Fügeteiloberfläche durch physikalische (und unter bestimmten Umständen auch durch chemische) Wechselwirkungen. Dieses Phänomen der Haftung wird auch Adhäsion genannt. Anders als das Schweißen oder das Löten gehört das Kleben zu den wärmearmen Fügeverfahren. Beim Kleben von Kunststoffen mit organischen Klebstoffen treten zudem Diffusionsprozesse zwischen Klebstoff und Fügeteil auf, die zur Adhäsion beitragen. Die gegenüber vielen Fügeteilmaterialien (wie z. B. Metallen, Gläsern) geringere Eigenfestigkeit der Klebstoffe kann häufig durch großflächige Klebungen kompensiert werden. Dies erfordert gegebenenfalls eine dem Kleben angepasste Konstruktion und Gestaltung der Klebestelle.

Technisch betrachtet ist das Kleben ein Fügeverfahren, welches nahezu alle Werkstoffe miteinander und untereinander verbinden kann. Dabei ist die Klebtechnik besonders schonend, da sie keiner großen Hitze bedarf, welche Verzug, Abkühlspannungen oder Gefügeveränderung der Fügeteile zur Folge haben kann. Zum Kleben werden auch keine schwächenden Löcher in den Fügeteilen benötigt, wie etwa beim Schrauben oder Nieten. Außerdem wird beim Kleben die Kraft flächig vom einen zum anderen Fügeteil übertragen. Die Eigenschaften des Klebens sind vor allem im Zusammenhang mit den wärmeempfindlichen LEDs sehr vorteilhaft. Gleichwohl können Teile der erfindungsgemäßen Baugruppe auch verschraubt oder vernietet sein.

Die vorliegende Erfindung ermöglicht je nach gewählter Ausführungsform insbesondere die Realisierung folgender vorteilhafter Wirkungen:
Die Widerstandsfähigkeit der gesamten Baugruppe gegen Feuer wird durch die erfindungsgemäße Konstruktion erheblich verbessert. Je nach gewählter Ausführungsform ermöglicht die vorliegende Erfindung insbesondere eine verbesserte Kühlung der LEDs und anderer Bauteile der Baugruppe. Hierfür ist eine Frontplatte aus einem gut oder sehr gut wärmeleitenden Material, vorzugsweise aus Aluminium, besonders gut geeignet.

Weitere Vorteile und Merkmale der Erfindung werden nachstehend mit Bezug auf die beigefügten schematischen Figuren erläutert. Hierin zeigen:
- Fig. 1: eine schematische Darstellung einer Explosionsansicht eines Ausführungsbeispiels einer erfindungsgemäßen Baugruppe;
- Figur 2:: eine schematische Darstellung einer Querschnittsansicht eines Ausführungsbeispiels einer erfindungsgemäßen Baugruppe;
- Figur 3:: eine schematische Darstellung einer Draufsicht eines Ausführungsbeispiels einer erfindungsgemäßen Baugruppe;
- Figur 4:: eine schematische Darstellung eines Details eines weiteren Ausführungsbeispiels;
- Figur 5:: eine Schnittansicht entlang der Linie A-A in Figur 4.

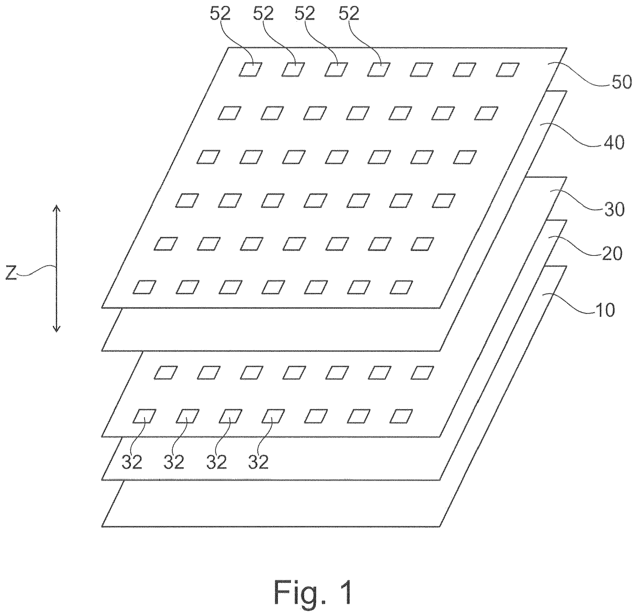

Die in Figur 1 gezeigte schematische Darstellung einer Explosionsansicht eines Ausführungsbeispiels einer erfindungsgemäßen Baugruppe weist in Richtung der in dieser Figur dargestellten z-Achse (Doppelpfeil Z) übereinander liegend eine Rückwand 10, eine optionale, mit elektronischen Bauelemente bestückte Platine 20, eine mit Leuchtdioden-Chips 32 (LED) bestückte Platine 30, eine transparente Schicht 40 und eine Frontwand 50 auf. Die Frontwand 50 entspricht zusammen mit der transparenten Schicht 40 einer Ausführungsform der zweiten Fläche (in der Terminologie der Ansprüche), wogegen die erste Fläche 20 in diesem Ausführungsbeispiel durch die Platine 30 verwirklicht wird.

Gleiche und gleichwirkende Komponenten sind in den Figuren in der Regel mit denselben Bezugszeichen versehen.

Alle in der Figur 1 eben dargestellten Flächen sind nicht in allen denkbaren oder vorteilhaften Ausführungsformen notwendig eben, sondern können zylindrisch, kegelförmig, kugelflächenförmig oder in anderer Weise gekrümmte Flächen mit endlichem Krümmungsradius bzw. endlichen Krümmungsradien sein. Da die Frontwand 50 in diesem Ausführungsbeispiel nicht als (in ausreichender Weise) transparent für das von den Leuchtdioden 32 emittierte Licht angenommen wird, weist die Frontwand 50 Ausnehmungen 52 auf, die eine Abstrahlung des durch die Leuchtdioden 32 emittierten Lichts wenigstens in flächennormaler Richtung ermöglicht. Da die ebenen oder gekrümmten Flächen 10, 20, 30, 40 und 50 im Wesentlichen parallel zu einander verlaufen, weist die Flächennormale (d.h. die zur Fläche senkrecht stehende Richtung) für alle parallel zu einander verlaufenden Flächen in jedem einzelnen Punkt in dieselbe Richtung, weshalb es gerechtfertigt ist, von "der" flächennormalen Richtung zu sprechen, wenn auch in dem in den Figuren nicht dargestellten Fall gekrümmter paralleler Flächen die Flächennormalen in zwei verschiedenen, z.B. benachbarten, Punkten in unterschiedliche Richtungen zeigen werden.

Die optionale Platine 20 kann beispielsweise mit Bauelementen bestückt sein, die zur zeitlich und/oder räumlich selektiven Ansteuerung der Leuchtdioden 32 benötigt werden. Selbstverständlich sind alle in der Figur 1 wie auch in den anderen Figuren gezeigten Merkmale der jeweiligen Ausführungsbeispiele optional in dem Sinn, dass der Gegenstand der vorliegenden Erfindung durch die Patentansprüche definiert wird und nicht durch die Figuren oder andere Ausführungsbeispiele, welche nur der Erläuterung der Patentansprüche dienen.

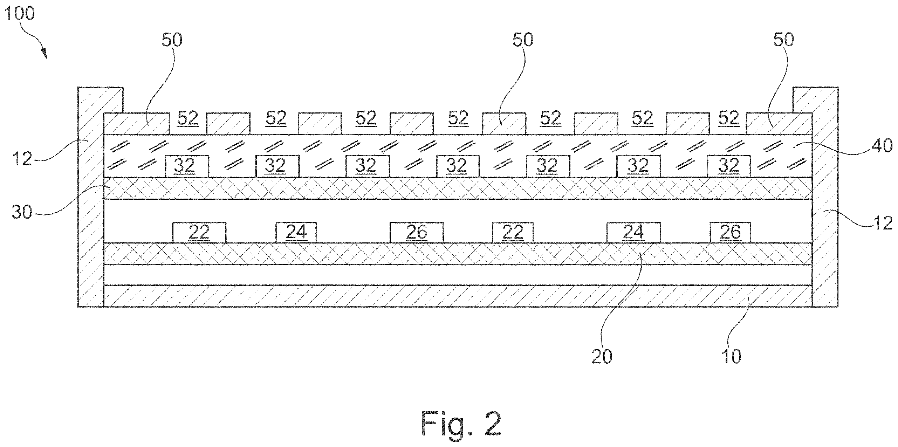

Die in Figur 2 gezeigte schematische Darstellung einer Querschnittsansicht eines Ausführungsbeispiels einer erfindungsgemäßen Baugruppe zeigt zusätzlich zu den in der Figur 1 gezeigten Elementen, nämlich der Rückwand 10, der mit Leuchtdioden-Chips 32 (LED) bestückte Platine 30, der transparenten Schicht 40 und der Frontwand 50 die mit elektronischen Bauelementen 22, 24 und 26 bestückte Platine 20 und Seitenwände 12. In diesem Ausführungsbeispiel sind die Zwischenräume zwischen den LED-Chips 30 im gesamten Bereich zwischen der Platine 30 und der Frontwand 50 mit dem transparenten Material 40 verfüllt.

Bei anderen Ausführungsbeispielen kann das transparente Material 40 unter anderem oder ausschließlich die Ausnehmungen 52 der Frontwand 50 ganz oder teilweise verfüllen oder es kann - beispielsweise als vorzugsweise dünnes Glasplättchen - an der Unterseite der Frontwand 50, vorzugsweise im Bereich der Ausnehmungen 52, diese vorzugsweise abschließend, angeordnet sein.

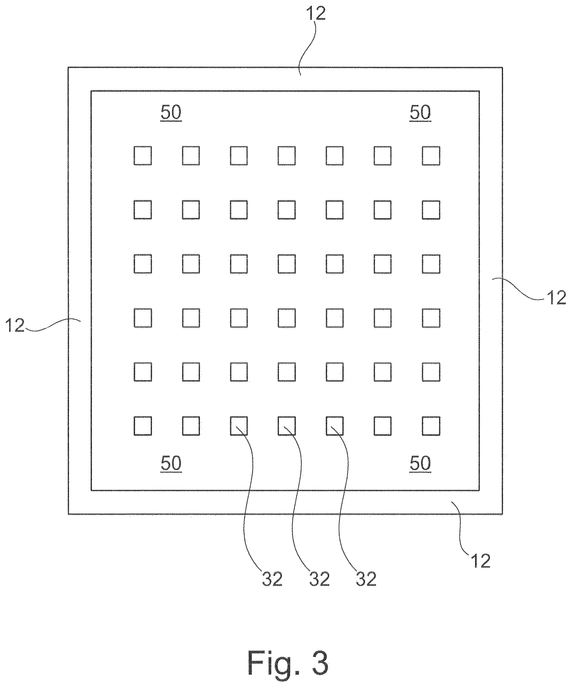

Die in Figur 3 gezeigte schematische Darstellung einer Draufsicht eines Ausführungsbeispiels einer erfindungsgemäßen Baugruppe zeigt außer der Frontplatte 50 die durch Ausnehmungen 52, die in der Frontplatte 50 gebildet sind, sichtbaren LED-Chips 32. Die Baugruppe wird durch die Seitenwände 12 zusammengehalten.

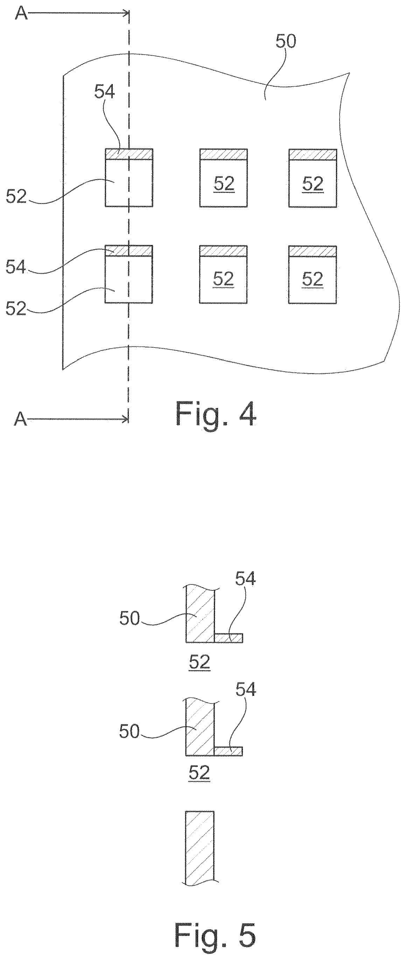

Die in Figur 4 gezeigte schematische Darstellung eines Details eines weiteren Ausführungsbeispiels einer erfindungsgemäßen Baugruppe zeigt die Ausnehmungen 52 mit Vorsprüngen 54 auf der Frontplatte 50. Die Ausnehmungen 52 haben einen rechteckigen Rand, der von vier geraden Linien begrenzt wird. An einer dieser vier Linien weist der Rand der Ausnehmungen jeweils einen Vorsprung 54 auf, der insbesondere zur Abschattung eines von oben kommenden Lichteinfalls dienen kann.

Die in Figur 5 gezeigte Schnittansicht entlang der Linie A-A in Figur 4 zeigt die Vorsprünge 54 an den Ausnehmungen 52 der Frontplatte 50 von der Seite.

Neben weiteren Ausführungsformen sind Ausführungen der vorliegenden Erfindung möglich, bei denen die Frontplatte 50 Aluminium aufweist, das die Baugruppe wenigstens teilweise wie eine Kapsel umschließt. Die Kapselung dient vorzugsweise als Witterungssperre und schützt die Platinen und/oder Bauelemente vorzugsweise vor eindringendem Wasser. Sie kann lackiert ausgeführt sein und/oder Materialien wie Klebstoffe (Glue) oder Silikone aufweisen.

Andere Ausführungsformen sehen einen Glas-Abschatter (Glas-Shader) vor, aus dem die Frontplatte gegossen wird. Die LEDs können Glasfaserelemente oder GlasLinsen aufweisen. Die auch als Backplane oder Backschicht bezeichnete Rückwand 10 kann auch ein Netzteil aufnehmen.

Die Zwischenräume in der Frontschicht der Baugruppe zwischen der Frontplatte und der Platine mit den LEDs wird vorzugsweise von einem feuerfesten (A1) Material ausgefüllt, das vorzugsweise einen nicht brennbaren und nicht organischen Stoff, beispielsweise Aluminium, Glas, Glasfaser und/oder ähnliches aufweist. Die Frontschicht kann lackiert, eloxiert oder pulverbeschichtet ausgeführt sein. Sie kann aus elektrischen Gründen elektrisch geerdet sein.

Die Frontschicht kann auch als Frontplatte bezeichnet werden. Die Frontschicht kann, insbesondere wenn die Zwischenräume zwischen den Leuchtdioden nicht verfüllt sind, ein für das Licht der Leuchtdioden transparentes Material, dass außerdem, hitzebeständig, feuerfest und/oder nicht brennbar ist, aufweisen und insbesondere aus diesem Material bestehen.

Bei einigen Ausführungsformen der vorliegenden Erfindung werden nur die Zwischenräume zwischen den LEDs mit dem A1-Material verfüllt. Die LEDs bzw. SMDs (Surface Mounted Devices) scheinen sozusagen durch das A1-Material hindurch. Bei anderen Ausführungsformen der vorliegenden Erfindung werden, vorzugsweise zusätzlich, Glasscheibchen auf den LEDs bzw. SMDs befestigt, vorzugsweise verklebt.

Dazu alternativ können die Glasscheibchen, anstatt sie auf die LEDs bzw. SMDs zu kleben, auch auf die vordere Teilplatte von zwei Teilplatten geklebt sein, aus denen die Frontplatte bei diesen Ausführungsformen bestehen kann. Eine der Teilplatten oder beide Teilplatten weisen vorzugsweise Aluminium auf. Die vordere Teilplatte wird mit der hinter ihr liegenden zweiten Teilplatte vorzugsweise verschraubt. Die Zwischenräume zwischen den LEDs bzw. SMDs werden vorzugsweise mit einem A1-Material verfüllt, das vorzugsweise optisch transparent ist.

Die LED-Platine 30 kann einschichtig oder mehrschichtig (d.h. als sogenannte MultiLayer-Platine) ausgeführt sein. Sie kann brennbare oder nichtbrennbare, vorzugsweise A1-Materialien, aufweisen. Sie kann mit insbesondere elektronischen Bauelementen wie beispielsweise Dimming-ICs, Widerständen oder anderen Bauteilen bestückt sein. Sie kann sogenannte Konnektoren und/oder Anschlussfelder aufweisen und weist auf der zur Frontplatte ausgerichteten Seite vorzugsweise nur LEDs und/oder SMDs auf, deren Abstrahlcharakteristik durch die Frontschicht, insbesondere durch die Frontplatte beeinflusst werden kann.

Die Elektronik-Platine 20 trägt, sofern vorhanden, vorzugsweise elektronische Bauteile, vorzugsweise eine CPU, Treiberchips, Widerstände, ein Netzteil oder ähnliches, zur Ansteuerung der elektronischen Bauteile auf der LED-Platine, vorzugsweise zur Ansteuerung der LEDs. Zwischen der Elektronik-Platine 20 und der Rückwand 10, der sogenannten Backschicht, können insbesondere Komponenten eines Netzteils, Konnektoren oder Anschlussfelder vorgesehen sein.

Die Backschicht kapselt die Bauteile der Baugruppe zur Rückseite aus einem vorzugsweise nicht brennbaren A1-Material. Die Backschicht kann Durchbrüche für elektrische Datenleitungen und/oder Stromversorgungsleitungen oder Anschlüsse aufweisen.

Die Seitenwände 12 kapseln den gesamten Aufbau, also die Baugruppe 100 zur Seite hin aus einem vorzugsweise nicht-brennbaren A1-Material, vorzugsweise so dicht, dass die Oberfläche feuerfest ist.

Einige oder alle Bauteile der Baugruppe, insbesondere die Gehäuse der LEDs, sind vorzugsweise aus einem anorganischen Material und/oder nicht brennbaren Material gefertigt oder weisen ein solches Material auf. Vorzugsweise handelt es sich um ein A1-Material oder um eine Kombination aus Materialien, die A1-Materialien aufweisen, insbesondere um Glasfaser und/oder Glaslinsen.

Die Frontschicht der Baugruppe kann vorzugsweise eine gegossene Frontschicht aus Glas sein. Die LEDs bzw. SMDs können mit einer Glaskappe oder Glaslinse versehen sein. Das hierfür verwendete Glas ist besonders vorzugsweise ein feuerfestes Glas, so dass die gegossene Frontplatte einen wirksamen Schutz gegen Feuer realisieren kann.

Die gegossene Frontplatte 40 aus Glas oder aus einem anderen optisch transparenten feuerfesten Material könnte vorzugsweise auf ihrer Innenseite die räumliche Struktur eines Negativs zur der direkt darunter befindlichen räumlichen Struktur der Oberseite der LED-Platine 30 sein, so dass durch ein passgenaues Zusammenfügen beider Platten eine solide Platte ohne Zwischenräume entsteht, weil die Zwischenräume der LED-Platine durch entsprechende Strukturen der Frontplatte ausgefüllt werden. Die Frontwand 50 könnte bei derartigen Ausführungsformen entfallen.

### Bezugszeichen

- 100: Baugruppe
- 10: Rückwand
- 12: Seitenwände
- 20: Platine mit Elektronik (optional)
- 22, 24, 26: Elektronikkomponenten
- 30: Platine mit LED-Chips
- 32: LED-Chips
- 40: transparente Schicht, z.B. Lack
- 50: Frontwand
- 52: Ausnehmungen in Frontwand
- 54: Vorsprung zur Abschattung von Licht, das von oben kommt, insbesondere Sonnenlicht

## Patentansprüche

1. Baugruppe (100) mit einer Mehrzahl von Leuchtdioden (32), die auf der Baugruppe durch Zwischenräume beabstandet angeordnet sind,
wobei die Zwischenräume zwischen den Leuchtdioden ein feuerfestes oder nicht brennbares Material aufweisen,
wobei eine Frontplatte vorhanden ist, die ein feuerfestes oder nicht brennbares Material aufweist, und
wobei die Leuchtdioden auf einer ersten Fläche (20, 30) angeordnet sind, **dadurch gekennzeichnet,**
**dass** die Frontplatte eine Frontplatte (40) aus einem optisch transparenten feuerfesten Material ist, die über den Leuchtdioden (32) liegt und
**dass** das hitzebeständige oder feuerfeste oder nicht brennbare Material in Form einer zweiten Fläche (40, 50) auf der ersten Fläche angebracht ist,
wobei die zweite Fläche, die für das von den Leuchtdioden emittierte Licht nicht oder nicht in ausreichender Weise durchlässig ist, eine Mehrzahl von Ausnehmungen (52) aufweist, die in der zweiten Fläche derart angeordnet sind, dass das von den Leuchtdioden emittierte Licht zumindest in flächennormaler Richtung nicht von der zweiten Fläche an der Abstrahlung gehindert wird.

2. Baugruppe nach Anspruch 1,
**dadurch gekennzeichnet,**
**dass** die Zwischenräume zwischen den Leuchtdioden ein hitzebeständiges oder feuerfestes oder nicht brennbares, vorzugsweise anorganisches, keramisches oder metallisches Material, besonders vorzugsweise Glas, Glasfaser oder Aluminium oder ein anderes Material der Brandschutzklasse A1 aufweisen.

3. Baugruppe nach einem der vorhergehenden Ansprüche,
**dadurch gekennzeichnet,**
**dass** die Leuchtdioden auf der ersten Fläche (20, 30) matrixförmig angeordnet sind.

4. Baugruppe nach Anspruch einem der Ansprüche 1 bis 3,
**dadurch gekennzeichnet,**
**dass** die Ausnehmungen mit einem hitzebeständigen oder feuerfesten oder nicht brennbaren Material (40) verfüllt sind, das für das von den Leuchtdioden emittierte Licht durchlässig oder zumindest in ausreichender Weise durchlässig ist.

5. Baugruppe nach einem der vorhergehenden Ansprüche,
**dadurch gekennzeichnet,**
**dass** auf den Leuchtdioden, insbesondere auf deren von der ersten Fläche abgewandten Seiten, jeweils für das Licht der Leuchtdioden zumindest ausreichend durchlässige Objekte aus einem hitzebeständigen oder feuerfesten oder nicht brennbaren Material, das vorzugsweise Glasscheibchen aufweist, befestigt, vorzugsweise mit diesen verklebt sind.

6. Baugruppe nach einem der Ansprüche 1 bis 5,
**dadurch gekennzeichnet,**
**dass** das hitzebeständige oder feuerfeste oder nicht brennbare Material in Form einer zweiten Fläche auf der ersten Fläche angebracht ist, wobei die zweite Fläche eine erste und eine zweite Teilfläche aufweist, beide Teilflächen eine Mehrzahl von Ausnehmungen aufweisen, die in den beiden Teilflächen der zweiten Fläche derart angeordnet sind, dass das von den Leuchtdioden emittierte Licht zumindest in flächennormaler Richtung nicht von der zweiten Fläche an der Abstrahlung gehindert wird, wobei an den Ausnehmungen in der von der ersten Fläche abgewandten Teilfläche jeweils für das Licht der Leuchtdioden zumindest ausreichend durchlässige Objekte aus einem hitzebeständigen oder feuerfesten oder nicht brennbaren Material, das vorzugsweise Glasscheibchen aufweist, auf der der ersten Fläche zugewandten Seite der von der ersten Fläche abgewandten Teilfläche befestigt, vorzugsweise mit dieser Teilfläche verklebt sind.

7. Baugruppe nach einem der Ansprüche 1 bis 6,
**dadurch gekennzeichnet,**
**dass** die Frontwand (50) an den Rändern der Ausnehmungen (52) in flächennormaler Richtung angeordnete Vorsprünge (54) aufweisen.

8. Baugruppe nach Anspruch 7,
**dadurch gekennzeichnet,**
**dass** die Vorsprünge (54) jeweils nur in einem Teilbereich der Randkurven oder Randlinien der Ausnehmungen (52) eine von Null verschiedene Höhe aufweisen.

9. Videoboard mit mindestens einer Baugruppe nach einem der Ansprüche 1 bis 8.

10. Videoboard nach Anspruch 9,
**dadurch gekennzeichnet,**
**dass** ein Gehäuse zum Aufnehmen der mindestens einen Baugruppe vorhanden ist,
**dass** Energieversorgungsmittel, insbesondere mindestens ein Netzteil, zum Versorgen der mindestens einen Baugruppe vorhanden sind, und
**dass** eine Ansteuereinrichtung, insbesondere Rechnerschnittstellen, zum Ansteuern der mindestens einen Baugruppe vorhanden ist.

## Claims

1. Assembly (100) with a plurality of light emitting diodes (32) which are arranged on the assembly spaced by interspaces,
wherein the interspaces between the light emitting diodes (32) comprise a fire-proof or non-flammable material,
wherein a front panel is present which comprises a fire-proof or non-flammable material, and
wherein the light emitting diodes are arranged on a first surface (20, 30), **characterized in**
**that** the front panel is a front panel (40) made from an optically transparent fire-proof material which lies over the light emitting diodes (32) and
**that** the heat-resistant or fire-proof or non-inflammable material is installed on the first surface in the form of a second surface (40, 50), where the second surface, which is not transparent or not sufficiently transparent for the light emitted by the light emitting diodes, comprises a plurality of recesses (52) which are arranged in the second surface such that the light emitted by the light emitting diodes, at least in the direction of a surface normal, is not inhibited from being irradiated by the second surface.

2. Assembly according to claim 1,
**characterized in**
**that** the interspaces between the light emitting diodes comprise a heat-resistant or fire-proof or non-flammable, preferably inorganic, ceramic or metallic material, particularly preferably glass, fiber-glass or aluminum or another material of the fire protection class A1.

3. Assembly according to one of the preceding claims,
**characterized in**
**that** the light emitting diodes are arranged on the first surface (20, 30) in matrix form.

4. Assembly according to one of the claims 1 to 4,
**characterized in**
**that** the recesses (52) are filled with a heat-resistant or fire-proof or non-inflammable material (40) which is transparent or at least sufficiently transparent for the light emitted by the light emitting diodes.

5. Assembly according to one of the preceding claims,
**characterized in**
**that** on the light emitting diodes, particularly on the sides of the light emitting diodes averted from the first surface, in each case, objects made of a heat-resistant or fire-proof or non-inflammable material, which preferably comprises glass platelets, are fixed and preferably glued to the light emitting diodes, the objects being at least sufficiently transparent for the light of the light emitting diodes.

6. Assembly according to one of the claims 1 to 5,
**characterized in**
**that** the heat-resistant or fire-proof or non-inflammable material is arranged on the first surface in the form of a second surface,
wherein
the second surface comprises a first and second partial surface,
both partial surfaces comprise a plurality of recesses which are arranged in both partial surfaces of the second surface such that the light emitted by the light emitting diodes, at least in the direction of a surface normal, is not inhibited by the second surface from being irradiated,
wherein, at the recesses in the partial surface distal from the first surface, in each case, objects are arranged on the side facing the first surface of the partial surface distal from the first surface,
which objects are transparent or at least sufficiently transparent for the light emitted by the light emitting diodes and are made from a heat-resistant or fire-proof or non-inflammable material which preferably comprises glass platelets.

7. Assembly according to one of the claims 1 to 6,
**characterized in**
**that** the front wall (50) comprises protrusions (54) in a direction of a surface normal at the boundaries of the recesses (52).

8. Assembly according to claim 7,
**characterized in**
**that** the protrusions (54) have a height different from 0 only in a partial region of the boundary curves or boundary lines of the recesses (52).

9. Video board including at least one assembly according to one of the claims 1 to 8.

10. Video board according to claim 9,
**characterized in**
**that** a housing for receiving of the at least one assembly is present and
**that** energy supply means are present, in particular at least one power supply, for supplying of the at least one assembly, and
**that** a control device, in particular computer interfaces, are present for controlling of the at least one assembly.

## Revendications

1. Module (100) avec une pluralité de diodes électroluminescentes (32), qui sont disposées de manière espacée par intervalles sur le module,
dans lequel les intervalles entre les diodes électroluminescentes présentent un matériau réfractaire ou non combustible,
dans lequel une plaque avant est présente, qui présente un matériau réfractaire ou non combustible, et
dans lequel les diodes électroluminescentes sont disposées sur une première surface (20, 30),
**caractérisé en ce**
**que** la plaque avant est une plaque avant (40) composée d'un matériau réfractaire optiquement transparent, qui se situe au-dessus des diodes électroluminescentes (32) et
**que** le matériau résistant à la chaleur ou réfractaire ou non combustible est appliqué sous forme d'une deuxième surface (40, 50) sur la première surface, dans lequel la deuxième surface, qui n'est pas ou n'est pas suffisamment transparente à la lumière émise par les diodes électroluminescentes, présente une pluralité d'évidements (52), qui sont disposés dans la deuxième surface de telle sorte que la lumière émise par les diodes électroluminescentes, au moins dans la direction normale à la surface, n'est pas empêchée de rayonner par la deuxième surface.

2. Module selon la revendication 1,
**caractérisé en ce**
**que** les intervalles entre les diodes électroluminescentes présentent un matériau résistant à la chaleur ou réfractaire ou non combustible, de préférence anorganique, céramique ou métallique, de manière particulièrement préférée du verre, des fibres de verre ou de l'aluminium ou un autre matériau de la classe de réaction au feu A1.

3. Module selon l'une quelconque des revendications précédentes,
**caractérisé en ce**
**que** les diodes électroluminescentes sont disposées en forme de matrice sur la première surface (20, 30).

4. Module selon la revendication l'une quelconque des revendications 1 à 3,
**caractérisé en ce**
**que** les évidements sont remplis d'un matériau (40) résistant à la chaleur ou réfractaire ou non combustible, qui est transparent ou au moins suffisamment transparent à la lumière émise par les diodes électroluminescentes.

5. Module selon l'une quelconque des revendications précédentes,
**caractérisé en ce**
**que** respectivement des objets au moins suffisamment transparents à la lumière des diodes électroluminescentes, composés d'un matériau résistant à la chaleur ou réfractaire ou non combustible, qui présente de préférence des rondelles de verre, sont fixés sur les diodes électroluminescentes, en particulier sur les faces de celles-ci opposées à la première surface, de préférence collés à celles-ci.

6. Module selon l'une quelconque des revendications 1 à 5,
**caractérisé en ce**
**que** le matériau résistant à la chaleur ou réfractaire ou non combustible est appliqué sur la première surface sous forme d'une deuxième surface, dans lequel la deuxième surface présente une première et une deuxième surface partielle, les deux surfaces partielles présentent une pluralité d'évidements, qui sont disposés dans les deux surfaces partielles de la deuxième surface de telle sorte que la lumière émise par les diodes électroluminescentes, au moins dans la direction normale à la surface, n'est pas empêchée de rayonner par la deuxième surface, dans lequel, sur les évidements dans la surface partielle opposée à la première surface, respectivement des objets au moins suffisamment transparents à la lumière des diodes électroluminescentes, composés d'un matériau résistant à la chaleur ou réfractaire ou non combustible, qui présente de préférence des rondelles de verre, sont fixés sur la face, tournée vers la première surface, de la surface partielle opposée à la première surface, de préférence collés à cette surface partielle.

7. Module selon l'une quelconque des revendications 1 à 6,
**caractérisé en ce**
**que** la paroi avant (50) présente sur les bords des évidements (52) des parties saillantes (54) disposés dans la direction normale à la surface.

8. Module selon la revendication 7,
**caractérisé en ce**
**que** les parties saillantes (54) présentent respectivement uniquement dans une zone partielle des courbes de bord ou lignes de bord des évidements (52) une hauteur différente de zéro.

9. Carte vidéo avec au moins un module selon l'une quelconque des revendications 1 à 8.

10. Carte vidéo selon la revendication 9,
**caractérisée en ce**
**qu'**un boîtier destiné à loger le au moins un module est présent,
**que** des moyens d'alimentation en énergie, en particulier au moins un bloc d'alimentation, destinés à alimenter le au moins un module, sont présents, et qu'un dispositif de commande, en particulier des interfaces d'ordinateur, destiné à commander le au moins un module, est présent.
